# EUROPÄISCHE PATENTSCHRIFT

(11) **EP 2 529 978 B1**
(45) Veröffentlichungstag und Bekanntmachung des Hinweises auf die Patenterteilung: **27.09.2017**
(21) Anmeldenummer: 12169351.9
(22) Anmeldetag: 24.05.2012
(51) Int. Cl.: B41J 29/13, B60R 11/00, G07C 5/06, G07C 5/08, H05K 5/02, G07C 5/02

(54) **Fahrzeugdatenaufzeichnungsgerät**
Vehicle data recording device
Appareil d'enregistrement de données de véhicules

(30) Priorität: 01.06.2011 DE 202011101626 U; 16.03.2012 DE 102012204204
(43) Veröffentlichungstag der Anmeldung: 05.12.2012
(73) Patentinhaber: Continental Automotive GmbH, 30165 Hannover (DE)
(72) Erfinder: Wahler, Torsten, 78073 Bad Dürrheim (DE)

(56) Entgegenhaltungen:
- DE-A1- 3 723 723
- DE-A1-102006 023 984
- US-A- 4 085 369
- US-A- 4 196 821
- US-A- 5 303 163
- US-A- 6 113 047

## Beschreibung

Die Erfindung bezieht sich auf ein Fahrzeugdatenaufzeichnungsgerät mit einem in einem Kraftfahrzeug befestigbaren Gehäuse.

Bekannte Fahrzeugdatenaufzeichnungsgeräte sind beispielsweise Fahrtschreiber. Ein eingangs genanntes Fahrzeugdatenaufzeichnungsgerät kann als Einbaugerät, das zum Beispiel in eine Armaturentafel oder ein Cockpit eines Kraftfahrzeugs eingebaut wird und bei dem sämtliche Bedien- und Anzeigeelemente sowie gegebenenfalls erforderliche Geräteöffnungen, beispielsweise eine Druckmaterialnachfüllöffnung für eine in dem Gehäuse angeordnete Druckvorrichtung oder eine Chipkarteneinführöffnung, an einer Gehäusefrontseite angeordnet sind, ausgebildet sein.

Nachteilig ist bei einem solchen Fahrzeugdatenaufzeichnungsgerät, dass für seinen Einbau regelmäßig ein spezieller Einbauraum, üblicherweise als Einbauschacht bezeichnet, in der Armaturentafel oder dem Cockpit des Kraftfahrzeugs vorgesehen sein muss. Dadurch ist ein freizügiger, insbesondere auch nachträglicher, Einbau des Fahrzeugdatenaufzeichnungsgeräts nicht immer möglich. Außerdem kann es sein, dass ein in dem Kraftfahrzeug vorhandener Einbauschacht bereits durch ein anderes Gerät belegt ist und für den Einbau des Fahrzeugdatenaufzeichnungsgeräts nicht mehr zur Verfügung steht.

Aus US 6 113 047 A ist ein in einem Lager, in welchem mittels Strichcodes identifizierbare Paletten, Pakete u. ä. bewegt werden, verwendetes Computerendgerät bekannt. Das Computerendgerät empfängt Strichcodeinformationen eines Strichcodelesers und kann an einem Armaturenbrett eines Gabelstaplers befestigt sein.

Aufgabe der Erfindung ist es, ein Fahrzeugdatenaufzeichnungsgerät der eingangs genannten Art zu schaffen, welches unabhängig von einem Einbauschacht und einfach in einem Kraftfahrzeug angebracht werden kann.

Diese Aufgabe wird erfindungsgemäß gelöst durch ein Fahrzeugdatenaufzeichnungsgerät nach Anspruch 1.

Bei dem Kraftfahrzeug handelt es sich vorzugsweise um ein gewerbliches Fahrzeug, insbesondere um ein Nutzfahrzeug oder einen Lastkraftwagen oder einen Kraftomnibus. Von besonderem Vorteil ist bei dem erfindungsgemäßen Fahrzeugdatenaufzeichnungsgerät, dass es nicht nur aufgrund des Bedienelementes an der Gehäusefrontseite und der Druckmaterialaufnahme an der Gehäuseoberseite sehr gut bedienbar ist, sondern dass es vor allem auch freizügig in einem Kraftfahrzeug angebracht werden kann; denn je nach Schwenklage des Tragbügels kann das Fahrzeugdatenaufzeichnungsgerät entweder als Aufbaugerät auf zum Beispiel eine Armaturentafel des Kraftfahrzeugs aufgebaut oder als Unterbaugerät unter zum Beispiel dem Dach einer Fahrerkabine des Kraftfahrzeugs hängend montiert oder als Anbaugerät, genauer Vorbaugerät, zum Beispiel an eine Mittelkonsole oder ein Cockpit des Kraftfahrzeugs angebaut werden, ohne dass sich seine Bedienbarkeit einschließlich der Zugänglichkeit der Druckmaterialaufnahme verschlechtert. Dieses wird bei der Erfindung insbesondere dadurch gewährleistet, dass die Schwenkachse oberhalb der Gehäusemittelachse angeordnet ist, wodurch sich bei einem Unterbau des Geräts ein großer Freiraum nach oben und damit eine gute Zugänglichkeit der Druckmaterialaufnahme sowie bei einem Aufbau des Geräts eine gedrungene Anordnung, welche insbesondere auch eine Sicht eines Fahrers des Kraftfahrzeugs nicht unnötig einschränkt, ergibt. Das erfindungsgemäße Fahrzeugdatenaufzeichnungsgerät ist somit vorteilhaft sehr variabel in einem Kraftfahrzeug, insbesondere in einem Fahrgastraum oder einer Fahrerkabine des Kraftfahrzeugs, anbringbar, da es beispielsweise sowohl auf waagerechten Flächen als auch an senkrechten oder steil abfallenden als auch über Kopf befestigbar ist, wobei in jeder Befestigungslage die Druckmaterialaufnahme zugänglich ist.

Durch die erfindungsgemäße Möglichkeit der Verschwenkbarkeit des Tragbügels von der Unterseite zur Oberseite des Gehäuses kann das Fahrzeugdatenaufzeichnungsgerät an einer ebenen Fläche nahezu beliebiger Neigung in dem Kraftfahrzeug befestigt werden. Innerhalb eines üblichen Toleranzbereiches kann der Tragbügel auch um einen um ein gewisses Maß von 180° abweichenden Winkel verschwenkbar sein. Grundsätzlich kann der Tragbügel auch über einen Winkel von deutlich mehr als 180° verschwenkbar sein. Für eine leichte Herstellbarkeit kann das Gehäuse vorzugsweise ein, üblicherweise mehrteiliges, Kunststoffbauteil sein. Für eine hohe Stabilität der Befestigung des Gehäuses im Kraftfahrzeug kann der Tragbügel vorzugsweise ein Metallbauteil sein oder vorteilhaft aus einem Glasfasern aufweisenden Faserverbundwerkstoff-Kunststoffmaterial gebildet sein.

Gemäß einer vorteilhaften Weiterbildung der Erfindung ist der Abstand zwischen einer eine Befestigungsfläche der Befestigungsplatte senkrecht schneidenden Plattenmittelachse und der Schwenkachse größer als Null. Auf diese Weise kann die Anordnung des Fahrzeugdatenaufzeichnungsgeräts in dem Kraftfahrzeug weiter vereinfacht werden. Außerdem kann damit auch eine gute Zugänglichkeit einer seitlich an dem Gehäuse angeordneten Geräteschnittstelle, zum Beispiel für einen externen Datenspeicher, sichergestellt werden. Vorzugsweise kann der oben genannte Abstand zwischen der Plattenmittelachse und der Schwenkachse in etwa so groß wie die quer zur Schwenkachse liegende Breite der Befestigungsplatte sein.

Es ist denkbar, die Tragschenkel beispielsweise mit einer vom Gehäuse seitlich weg weisenden Kröpfung zu versehen. Besonders vorteilhaft ist es hingegen, wenn gemäß einer anderen Weiterbildung der Erfindung die Tragschenkel eben ausgebildet und unter einem Winkel von 90° mit der Befestigungsplatte verbunden sind, wenn der erste Tragschenkel in seiner Tragschenkelebene ausgehend von der Schwenkachse in Richtung der Befestigungsplatte eine Abwinklung aufweist und wenn der zweite Tragschenkel eine mit der Abwinklung des ersten Tragschenkels korrespondierende Abwinklung aufweist, so dass die Tragschenkel parallel verlaufen. Damit wird ein sehr schmales, platzsparendes Fahrzeugdatenaufzeichnungsgerät erreicht, das zudem in einem vorderen, bedienernäheren Bereich einer seitlichen Gehäusewandung des Gehäuses einen Freiraum für zum Beispiel eine Geräteschnittstelle aufweisen kann. Die Geräteschnittstelle ist vorzugsweise eine Schnittstelle für einen Anschluss eines externen Datenspeichers; insbesondere kann die Geräteschnittstelle eine USB(Universal Serial Bus)-Schnittstelle zum Anschluss eines USB-Flash-Speichers, auch unter der Bezeichnung USB-Speicherstick bekannt, sein. Mit der Abwinklung weisen die Tragschenkel eine abgeknickte oder geschwungene Form auf.

Man könnte sich vorstellen, dass das Gehäuse mit den Tragschenkeln beispielsweise verklipst oder verklebt ist. Von besonderem Vorteil ist es hingegen, wenn entsprechend einer anderen Weiterbildung der Erfindung das Gehäuse mittels jeweils einer Verschraubung mit dem ersten Tragschenkel und mit dem zweiten Tragschenkel verbunden ist. Auf diese Weise ist nicht nur eine sichere Verbindung zwischen Gehäuse und Tragbügel gewährleistet, sondern zudem besteht durch Anpassung des Schwenkwinkels des Tragbügels gegenüber dem Gehäuse auch die Möglichkeit einer besonders benutzerfreundlichen Anordnung des Fahrzeugdatenaufzeichnungsgeräts im Kraftfahrzeug, so dass sowohl das Bedienelement der Gehäusefrontseite als auch die Druckmaterialaufnahme der Druckvorrichtung besonders leicht zugänglich ist. Vorzugsweise legen die beiden Verschraubungen die Schwenkachse fest.

Ein kostengünstiger Aufbau der Verschraubung und eine leichte Demontierbarkeit des Gehäuses von dem Tragbügel, beispielsweise zu Reparaturzwecken, wird vorteilhaft erreicht, wenn gemäß einer Weiterbildung der Erfindung die Tragschenkel im Bereich der Verschraubungen Ausnehmungen aufweisen und wenn die Tragschenkel mittels jeweils eines Einschraubelementes mit dem Gehäuse verschraubt sind.

Grundsätzlich ist es vorstellbar, dass die Verschraubungen zum Beispiel eine lose Schraubmutter aufweisen. Der Zusammenbau des Fahrzeugdatenaufzeichnungsgeräts wird jedoch wesentlich vereinfacht, wenn gemäß einer anderen vorteilhaften Weiterbildung der Erfindung das Gehäuse im Bereich der Verschraubungen jeweils ein Schraubmutterelement aufweist. Die Schraubmutterelemente können in seitlichen Gehäusewandungen des Gehäuses ausgebildet sein; dazu kann beispielsweise ein Gewinde an einer als Kunststoffbauteil ausgebildeten Gehäusewandung mit angeformt sein. Vorzugsweise sind die Schraubmutterelemente aber jeweils als Einpressmutter von innen in eine seitliche Gehäusewandung des Gehäuses eingepresst. Vorzugsweise sind die Einpressmuttern derart ausgebildet, dass bei einem Anziehen von Einschraubelementen die Einpressmuttern nicht durchdrehen oder herausgezogen werden können.

Eine vorgesehene Winkellage zwischen Gehäuse und Tragschenkeln könnte beispielsweise allein mithilfe einer Reib- oder Klemmkraft zwischen Gehäuse und Tragschenkeln aufrechterhalten werden. Zur Verbesserung der Stabilität und Lagehaltung sieht eine andere vorteilhafte Weiterbildung der Erfindung vor, dass das Gehäuse an seiner Außenseite radial um die Schwenkachse angeordnete Gehäuserastelemente aufweist. Die Gehäuserastelemente können nicht nur vorteilhaft zu einer Erhöhung von Reib- und Klemmkraft beitragen, sondern sie können zudem einen Formschluss zwischen Gehäuse und Tragbügel herbeiführen.

Grundsätzlich ist es bereits vorteilhaft, wenn die Gehäuserastelemente nur an einer Gehäuseseite vorgesehen sind. Jedoch wird die Stabilität vorteilhaft zusätzlich verbessert, wenn gemäß einer Weiterbildung der Erfindung das Gehäuse mit beiden Tragschenkeln verschraubt ist und wenn das Gehäuse die Gehäuserastelemente an beiden Verschraubungen mit den Tragschenkeln aufweist.

Vorteilhaft kann die Stabilität und Lagehaltung der Verbindung von Gehäuse und Tragbügel auch dadurch weiter gesteigert werden, dass gemäß einer anderen Weiterbildung der Erfindung zumindest ein Tragschenkel an seiner dem Gehäuse zugewandten Schenkeloberfläche radial um die Schwenkachse angeordnete Tragschenkelrastelemente aufweist.

Besonders vorteilhaft für eine dauerhaft zuverlässige, winkelstabile Verbindung von Tragbügel und Gehäuse ist es, wenn entsprechend einer Weiterbildung der Erfindung die Tragschenkelrastelemente mit Gehäuserastelementen an der Außenseite des Gehäuses korrespondieren, so dass die Tragschenkelrastelemente und die korrespondierenden Gehäuserastelemente ineinander eingreifen. Diese Gehäuserastelemente können den weiter oben beschriebenen Gehäuserastelementen entsprechen, sie können aber auch abweichend ausgebildet sein: Beispielsweise ist es denkbar, dass die Gehäuserastelemente in Form von nicht ausgerichteten Noppen an der Außenseite des Gehäuses ausgebildet sind. Besonders vorteilhaft ist es, wenn eine große Anzahl von Rastmöglichkeiten vorgesehen ist, so dass sich eine feine Winkelrasterung bei einer Ausrichtung des Gehäuses im Kraftfahrzeug ergibt.

Gemäß einer anderen vorteilhaften Weiterbildung der Erfindung weist die Befestigungsplatte in ihrer Befestigungsfläche eine Vielzahl von Befestigungsausnehmungen auf, wobei die Befestigungsausnehmungen in zumindest zwei parallelen Reihen angeordnet sind. Damit wird eine besonders einfache Befestigung in unterschiedlichsten Kraftfahrzeugen ermöglicht.

Einer anderen vorteilhaften Weiterbildung der Erfindung entsprechend weist die Befestigungsplatte in ihrer Befestigungsfläche eine Ausnehmung für eine Kabeldurchführung auf. Durch diese Ausnehmung kann insbesondere ein Anschlusskabel für das Fahrzeugdatenaufzeichnungsgerät sicher und geführt verlegt und zudem eine gegebenenfalls zur Durchführung des Anschlusskabels erforderliche Öffnung in einer Innenraumverkleidung des Kraftfahrzeugs, zum Beispiel in einer Armaturentafel oder in einem sogenannten Dachhimmel, abgedeckt werden. Vorzugsweise kann die Ausnehmung in der Befestigungsplatte kreisförmig ausgebildet sein.

Das Bedienelement der Gehäusefrontseite könnte beispielsweise einen einfachen Drückschalter oder einen Drehschalter aufweisen. Besonders vorteilhaft ist es jedoch, wenn einer anderen Weiterbildung der Erfindung entsprechend das Bedienelement der Gehäusefrontseite einen berührungsempfindlichen Bildschirm aufweist. Auf diese Weise werden nicht nur besonders vielfältige Bedieneingaben in das Fahrzeugdatenaufzeichnungsgerät durch den Benutzer ermöglicht, sondern es können mit dem Bedienelement auch Informationen an den Benutzer ausgegeben werden.

Es ist denkbar, dass der Tragbügel für eine besonders hohe Stabilität als Metallbauteil ausgebildet ist. Eine Reduzierung der Herstellkosten des Fahrzeugdatenaufzeichnungsgeräts kann jedoch vorteilhaft dadurch erreicht werden, dass der Tragbügel aus einem Kunststoffmaterial gebildet ist. Beispielsweise ein Polyamid
(PA) ist als Kunststoffmaterial für den Tragbügel geeignet. Besonders vorteilhaft ist ein aus einem Kunststoffmaterial gebildeter Tragbügel zudem dann, wenn das Fahrzeugdatenaufzeichnungsgerät zur externen Kommunikation einen Sender und/oder Empfänger für Funksignale aufweist; mit einem aus einem Kunststoffmaterial gebildeten Tragbügel kann eine ungünstige Beeinflussung oder gar Abschirmung der Sende- und/oder Empfangssignale des Senders beziehungsweise Empfängers vorteilhaft vermieden werden. Beispielsweise kann der genannte Vorteil dann zum Tragen kommen, wenn die Funksignale GPS(Global Positioning System)-Signale sind und das Fahrzeugdatenaufzeichnungsgerät eine Einrichtung zum Empfang von GPS-Signalen aufweist. Ein anderes Beispiel, bei dem der genannte Vorteil zum Tragen kommen kann, ist der Empfangs- und Sendebetrieb einer GSM(Global System for Mobile Communications)-Antenne, wenn das Fahrzeugdatenaufzeichnungsgerät eine GSM-Einheit mit einer GSM-Antenne aufweist.

Es ist vorgesehen, dass das Kunststoffmaterial ein Faserverbundwerkstoff ist und Glasfasern aufweist. Dadurch wird die Stabilität des Tragbügels wesentlich erhöht. Der Anteil der Glasfasern an dem Faserverbundwerkstoff kann vorzugsweise 30 bis 50 Volumenprozent betragen.

Ausführungsbeispiele der Erfindung sind in der Zeichnung dargestellt und werden im Folgenden näher beschrieben. Es zeigen in schematisierter, skizzenhafter Darstellung:
- Figur 1: ein Fahrzeugdatenaufzeichnungsgerät in einer perspektivischen Ansicht,
- Figuren 2, 3: das Fahrzeugdatenaufzeichnungsgerät aus Figur 1 in einer ersten Variante in Seitenansichten,
- Figuren 4, 5: das Fahrzeugdatenaufzeichnungsgerät aus Figur 1 in einer zweiten Variante in Seitenansichten und
- Figur 6: einen Tragbügel des Fahrzeugdatenaufzeichnungsgerät aus Figur 1 in einer perspektivischen Ansicht.

Sich entsprechende Elemente sind in allen Figuren mit jeweils gleichen Bezugszeichen versehen.

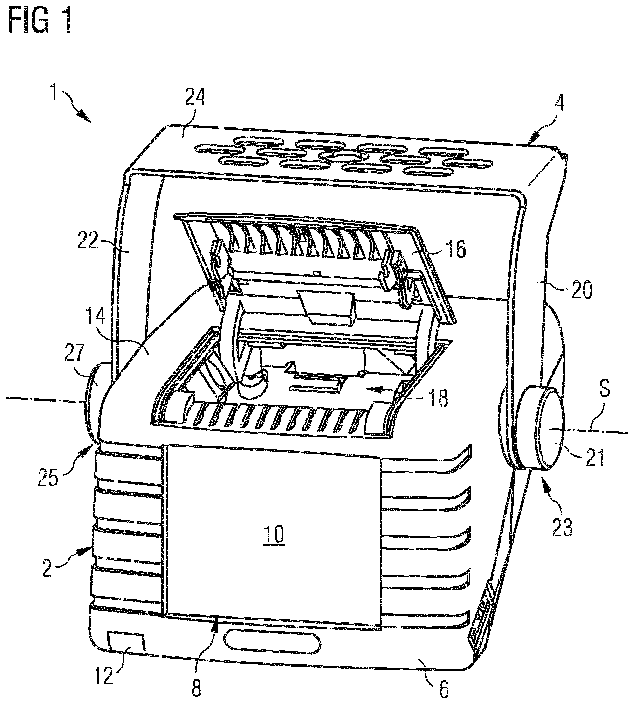

In Figur 1 ist ein Fahrzeugdatenaufzeichnungsgerät 1 mit einem Gehäuse 2 und einem U-förmigen Tragbügel 4 zur Befestigung des Gehäuses 2 in einem hier nicht dargestellten Kraftfahrzeug gezeigt. Das Gehäuse 2 weist eine einem hier nicht dargestellten Benutzer, insbesondere einem Fahrer des Kraftfahrzeugs, zugewandte Gehäusefrontseite 6 mit einem Bedienelement 8, das hier einen berührungsempfindlichen Bildschirm 10 aufweist, auf; eine andere Bezeichnung für den berührungsempfindlichen Bildschirm 10 ist Touch Screen. Ferner ist an der Gehäusefrontseite 6 ein weiteres, als Ein-Aus-Schalter für das Fahrzeugdatenaufzeichnungsgerät 1 ausgebildetes Bedienelement 12 vorgesehen.

Eine Gehäuseoberseite 14 des Gehäuses 2 weist einen mittels eines Deckels 16, hier Klappdeckels, verschließbaren Zugang zu einer Druckmaterialaufnahme 18 einer in dem Gehäuse 2 angeordneten Druckvorrichtung des Fahrzeugdatenaufzeichnungsgeräts 1 auf. Die Druckvorrichtung kann beispielsweise eine Thermodruckvorrichtung und das Druckmaterial kann auf einen Bandwickel aufgerolltes Druckpapier sein.

Der in diesem Ausführungsbeispiel als Metallbauteil ausgebildete Tragbügel 4 weist einen ersten Tragschenkel 20, einen zweiten Tragschenkel 22 und eine die Tragschenkel 20, 22 verbindende Befestigungsplatte 24 auf. Alternativ kann der Tragbügel 4 in diesem Ausführungsbeispiel statt als Metallbauteil aus einem Kunststoffmaterial, welches Kunststoffmaterial beispielsweise ein Faserverbundwerkstoff ist und Glasfasern zur Stabilitätserhöhung aufweist, gebildet sein. Das Gehäuse 2 ist zwischen den Tragschenkeln 20, 22 angeordnet, wobei das Gehäuse 2 um eine Schwenkachse S schwenkbar mit dem ersten Tragschenkel 20 und dem zweiten Tragschenkel 22 verbunden ist. Dabei ist das Gehäuse 2 mittels jeweils einer Verschraubung 23, 25 mit dem ersten Tragschenkel 20 und dem zweiten Tragschenkel 22 verbunden, wobei die Tragschenkel 20, 22 mittels jeweils eines Einschraubelementes 21, 27 mit dem Gehäuse 2 verschraubt sind.

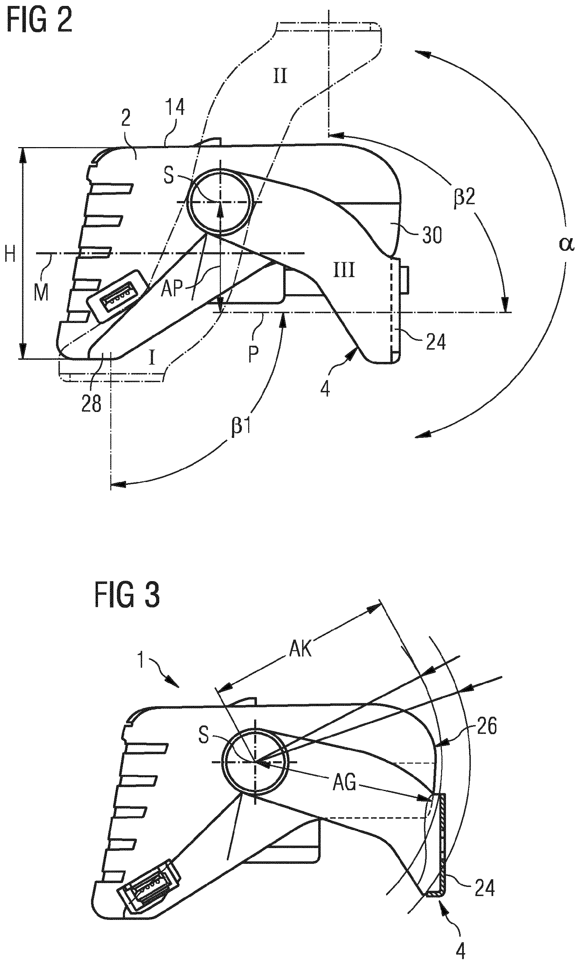

In der Seitenansicht nach Figuren 2, 3 ist zu erkennen, dass die Schwenkachse S oberhalb einer auf die Höhe H des Gehäuses 2 bezogenen Gehäusemittelachse M angeordnet ist. Ferner ist zu erkennen, dass der kleinste Abstand AK zwischen der Schwenkachse S und der Befestigungsplatte 24 des Tragbügels 4 größer ist als der größte Abstand AG zwischen der Schwenkachse S und einer rückseitigen Gehäusewandung 26 des Gehäuses 2, so dass der Tragbügel 4 zwischen einer ersten Position I in einem Bereich unterhalb einer Gehäuseunterseite 28 und einer zweiten Position II in einem Bereich oberhalb der Gehäuseoberseite 14 über einen Winkel α von 180° über eine Gehäuserückseite 30 des Gehäuses 2 verschwenkbar ist. Innerhalb eines üblichen Toleranzbereiches kann der Winkel α auch von dem angegebenen Wert 180° abweichen; insbesondere könnte der Winkel α aber auch deutlich größer als 180° sein.

Die rückseitige Gehäusewandung 26 weist hier die Gehäuserückseite 30 auf und kann darüber hinaus auch weitere Gehäuseabschnitte umfassen.

Der Tragbügel 4 ist in Figur 2 zur Verdeutlichung der Verschwenkbarkeit in den genannten Positionen I, II jeweils mit Strich-Zweipunktlinie eingezeichnet. Die erstgenannte Position I, in der die Befestigungsplatte 24 waagerecht ausgerichtet ist, ermöglicht beispielsweise einen Aufbau des Fahrzeugdatenaufzeichnungsgeräts 1 auf eine Armaturentafel des Kraftfahrzeugs; die zweitgenannte Position II, in der die Befestigungsplatte 24 ebenfalls waagerecht ausgerichtet ist, ermöglicht beispielsweise einen Unterbau des Fahrzeugdatenaufzeichnungsgeräts 1 unter ein Dach einer Fahrerkabine des Kraftfahrzeugs. In einer weiteren Position III, in welcher der Tragbügel 4 in Figur 2 mit durchgezogener Linie eingezeichnet ist, ist die Befestigungsplatte 24 senkrecht angeordnet; in dieser Position III des Tragbügels 4 ist beispielsweise ein Vorbau des Fahrzeugdatenaufzeichnungsgeräts 1 vor eine Armaturentafel des Kraftfahrzeugs ermöglicht. Ausgehend von der letztgenannten Position III des Tragbügels 4 sind in Figur 2 zur Veranschaulichung zwei Teilschwenkwinkel β1, β2, die hier jeweils 90° umfassen, zu den weiter oben genannten Positionen I, II eingezeichnet. Zwischen diesen oben genannten Positionen I, II kann die Befestigungsplatte 24 an jeder beliebigen geneigten Ebene im Kraftfahrzeug befestigt werden.

Ferner ist zu erkennen, dass der Abstand AP zwischen einer eine Befestigungsfläche der Befestigungsplatte 24 senkrecht schneidenden Plattenmittelachse P und der Schwenkachse S größer als Null ist. Der genannte Abstand AP ist hier in etwa so groß wie die quer zur Schwenkachse liegende Breite der Befestigungsplatte 24.

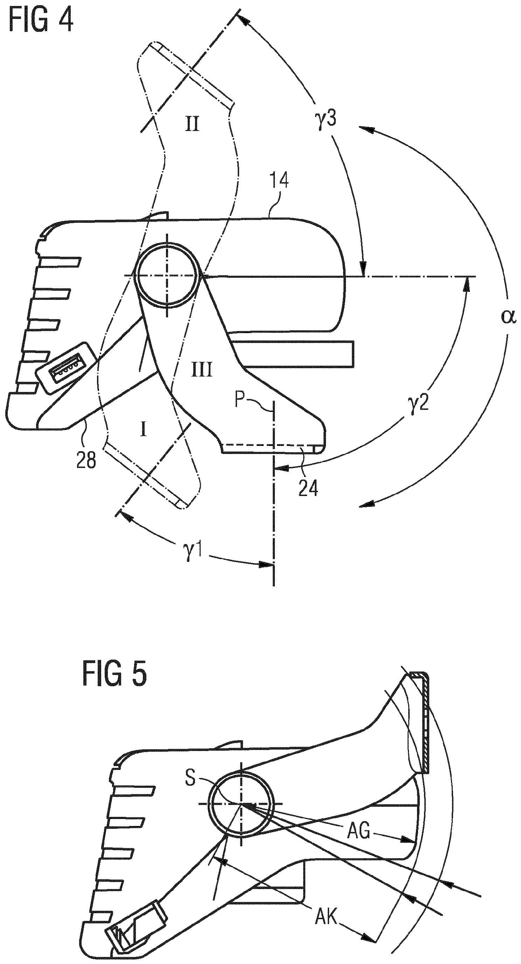

In einer in Figuren 4, 5 in Seitenansichten gezeigten anderen Variante des Fahrzeugdatenaufzeichnungsgeräts 1 nach Figur 1 ist der Tragbügel 4 mit dem Gehäuse 2 in einer um die Plattenmittelachse P um 180° gedrehten Anordnung verbunden. Je nach Anordnung des Tragbügels 4 bezüglich des Gehäuses 2 kann die Befestigungsplatte 24 somit vor- oder zurückversetzt sein. Damit erschließen sich zusätzliche mögliche Lageanordnungen des Fahrzeugdatenaufzeichnungsgeräts 1 in dem Kraftfahrzeug.

In Figur 4 ist der Tragbügel 4 in einer mittleren Position III mit durchgezogener Linie eingezeichnet. In dieser Position III ist hier die Befestigungsplatte 24 waagerecht angeordnet. Zur Verdeutlichung der Verschwenkbarkeit des Tragbügels 4 ist auch in Figur 4 der Tragbügel 4 in einer ersten Position I in einem Bereich unterhalb der Gehäuseunterseite 28 und in einer zweiten Position II in einem Bereich oberhalb der Gehäuseoberseite 14 jeweils mit Strich-Zweipunktlinie eingezeichnet. Zwischen der mittleren Position III und der ersten Position I liegt hier ein Teilschwenkwinkel γ1 von 38°, zwischen der mittleren Position III und der zweiten Position II liegt hier ein sich aus zwei Teilschwenkwinkeln γ2, γ3 von 90° und 52° zusammensetzender Winkel.

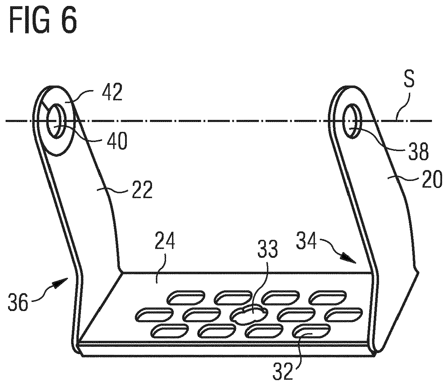

In Figur 6 ist der Tragbügel 4 des Fahrzeugdatenaufzeichnungsgeräts 1 nach Figur 1 einzeln dargestellt. Die Befestigungsplatte 24 weist in ihrer Befestigungsfläche eine Vielzahl von Befestigungsausnehmungen 32 auf, welche Befestigungsausnehmungen 32 in zumindest zwei parallelen Reihen angeordnet sind. In diesem Ausführungsbeispiel sind die Befestigungsausnehmungen 32 als Langlöcher ausgebildet. Mittig in der Befestigungsplatte 24 ist zusätzlich eine kreisförmige Ausnehmung 33 vorgesehen. Durch diese Ausnehmung 33 kann beispielsweise ein Anschlusskabel für das Fahrzeugdatenaufzeichnungsgerät 1 verlegt und somit eine zur Durchführung des Anschlusskabels erforderliche Öffnung in einer Innenraumverkleidung des Kraftfahrzeugs, zum Beispiel einer Armaturentafel oder einem sogenannten Dachhimmel, kaschiert werden.

Die Tragschenkel 20, 22 sind eben ausgebildet, und der erste Tragschenkel 20 weist in seiner Tragschenkelebene ausgehend von der Schwenkachse S eine Abwinklung 34 auf. Der zweite Tragschenkel 22 weist eine mit der Abwinklung 34 des ersten Tragschenkels 20 korrespondierende Abwinklung 36 auf, so dass die Tragschenkel 34, 36 parallel verlaufen. Mit den Abwinklungen 34, 36 weisen die Tragschenkel 20, 22 in dem hier gezeigten Ausführungsbeispiel eine geschwungene Form auf.

Im Bereich der Verschraubungen 23, 25 (siehe Figur 1) weisen die Tragschenkel 20, 22 Ausnehmungen 38, 40 auf. Aufgrund der perspektivischen Darstellung hier nur an der Ausnehmung 40 des zweiten Tragschenkels 22 erkennbar, weisen die Tragschenkel 20, 22 an ihrer dem Gehäuse 2 (siehe Figur 1) zugewandten Schenkeloberfläche radial um die Schwenkachse S angeordnete Tragschenkelrastelemente 42 auf.

## Patentansprüche

1. Fahrzeugdatenaufzeichnungsgerät (1) mit einem eine einem Benutzer zugewandte, ein Bedienelement (8) aufweisende Gehäusefrontseite (6) aufweisenden Gehäuse (2) und mit einem U-förmigen Tragbügel (4) zur Befestigung des Gehäuses (2) in einem Kraftfahrzeug, wobei das Fahrzeugdatenaufzeichnungsgerät zur externen Kommunikation einen Sender und/oder Empfänger für Funksignale aufweist,
wobei das Gehäuse (2) um eine Schwenkachse (S) schwenkbar mit einem ersten Tragschenkel (20) und einem zweiten Tragschenkel (22) des Tragbügels (4) verbunden ist,
wobei die Schwenkachse (S) oberhalb einer auf die Höhe (H) des Gehäuses (2) bezogenen Gehäusemittelachse (M) angeordnet ist und
wobei der kleinste Abstand (AK) zwischen der Schwenkachse (S) und einer die Tragschenkel (20, 22) verbindenden Befestigungsplatte (24) des Tragbügels (4) größer ist als der größte Abstand (AG) zwischen der Schwenkachse (S) und einer rückseitigen Gehäusewandung (26) des Gehäuses (2), **dadurch gekennzeichnet, dass** das Fahrzeugdatenaufzeichnungsgerät (1) ein Fahrtschreiber ist, dass das Gehäuse (2) eine einen Zugang zu einer Druckmaterialaufnahme (18) einer Druckvorrichtung aufweisende Gehäuseoberseite (14)aufweist und dass der Tragbügel (4) zwischen einer ersten Position (I) in einem Bereich unterhalb einer Gehäuseunterseite (28) und einer zweiten Position (II) in einem Bereich oberhalb der Gehäuseoberseite (14) über einen Winkel (α) von 180° über eine Gehäuserückseite (30) verschwenkbar ist,
wobei der Tragbügel (4) aus einem Kunststoffmaterial gebildet ist und wobei das Kunststoffmaterial ein Faserverbundwerkstoff ist und Glasfasern aufweist.

2. Fahrzeugdatenaufzeichnungsgerät nach Anspruch 1, **dadurch gekennzeichnet, dass** der Abstand (AP) zwischen einer eine Befestigungsfläche der Befestigungsplatte (24) senkrecht schneidenden Plattenmittelachse (P) und der Schwenkachse (S) größer als Null ist.

3. Fahrzeugdatenaufzeichnungsgerät nach Anspruch 1 oder 2, **dadurch gekennzeichnet, dass** die Tragschenkel (20, 22) eben ausgebildet und unter einem Winkel von 90° mit der Befestigungsplatte (24) verbunden sind, dass der erste Tragschenkel (20) in seiner Tragschenkelebene ausgehend von der Schwenkachse (S) in Richtung der Befestigungsplatte (24) eine Abwinklung (34) aufweist und dass der zweite Tragschenkel (22) eine mit der Abwinklung (34) des ersten Tragschenkels (20) korrespondierende Abwinklung (36) aufweist, so dass die Tragschenkel (20, 22) parallel verlaufen.

4. Fahrzeugdatenaufzeichnungsgerät nach einem der vorhergehenden Ansprüche, **dadurch gekennzeichnet, dass** das Gehäuse (2) mittels jeweils einer Verschraubung (23, 25) mit dem ersten Tragschenkel (20) und mit dem zweiten Tragschenkel (22) verbunden ist.

5. Fahrzeugdatenaufzeichnungsgerät nach Anspruch 4, **dadurch gekennzeichnet, dass** die Tragschenkel (20, 22) im Bereich der Verschraubungen (23, 25) Ausnehmungen (38, 40) aufweisen und dass die Tragschenkel (20, 22) mittels jeweils eines Einschraubelementes (21, 27) mit dem Gehäuse (2) verschraubt sind.

6. Fahrzeugdatenaufzeichnungsgerät nach Anspruch 4 oder 5, **dadurch gekennzeichnet, dass** das Gehäuse (2) im Bereich der Verschraubungen (23, 25) jeweils ein Schraubmutterelement aufweist.

7. Fahrzeugdatenaufzeichnungsgerät nach einem der vorhergehenden Ansprüche, **dadurch gekennzeichnet, dass** das Gehäuse (2) an seiner Außenseite radial um die Schwenkachse (S) angeordnete Gehäuserastelemente aufweist.

8. Fahrzeugdatenaufzeichnungsgerät nach Anspruch 7, **dadurch gekennzeichnet, dass** das Gehäuse (2) mit beiden Tragschenkeln (20, 22) verschraubt ist und dass das Gehäuse (2) die Gehäuserastelemente an beiden Verschraubungen (23, 25) mit den Tragschenkeln (20, 22) aufweist.

9. Fahrzeugdatenaufzeichnungsgerät nach einem der vorhergehenden Ansprüche, **dadurch gekennzeichnet, dass** zumindest ein Tragschenkel (22) an seiner dem Gehäuse (2) zugewandten Schenkeloberfläche radial um die Schwenkachse (S) angeordnete Tragschenkelrastelemente (42) aufweist.

10. Fahrzeugdatenaufzeichnungsgerät nach Anspruch 9, **dadurch gekennzeichnet, dass** die Tragschenkelrastelemente (42) mit Gehäuserastelementen an der Außenseite des Gehäuses (2) korrespondieren, so dass die Tragschenkelrastelemente (42) und die korrespondierenden Gehäuserastelemente ineinander eingreifen.

11. Fahrzeugdatenaufzeichnungsgerät nach einem der vorhergehenden Ansprüche, **dadurch gekennzeichnet, dass** die Befestigungsplatte (24) in ihrer Befestigungsfläche eine Vielzahl von Befestigungsausnehmungen (32) aufweist, wobei die Befestigungsausnehmungen (32) in zumindest zwei parallelen Reihen angeordnet sind.

12. Fahrzeugdatenaufzeichnungsgerät nach einem der vorhergehenden Ansprüche, **dadurch gekennzeichnet, dass** die Befestigungsplatte (24) in ihrer Befestigungsfläche eine Ausnehmung (33) für eine Kabeldurchführung aufweist.

13. Fahrzeugdatenaufzeichnungsgerät nach einem der vorhergehenden Ansprüche, **dadurch gekennzeichnet, dass** das Bedienelement (8) der Gehäusefrontseite (6) einen berührungsempfindlichen Bildschirm (10) aufweist.

## Claims

1. Vehicle data recording device (1) with a housing (2), having a housing front side (6) which faces a user and has an operator control element (8), and with a U-shaped supporting bracket (4) for mounting the housing (2) in a motor vehicle,
wherein the vehicle data recording device has, for external communication, a transmitter and/or receiver for radio signals,
wherein the housing (2) is connected to a first supporting limb (20) and a second supporting limb (22) of the supporting bracket (4) in such a way that it can pivot about a pivoting axis (S),
wherein the pivoting axis (S) is arranged above a housing central axis (M) with respect to the height (H) of the housing (2), and
wherein the smallest distance (AK) between the pivoting axis (S) and a mounting plate (24), connecting the supporting limb (20, 22), of the supporting bracket (4) is larger than the largest distance (AG) between the pivoting axis (S) and a rear-side housing wall (26) of the housing (2), **characterized in that** the vehicle data recording device (1) is a tachograph, **in that** the housing (2) has a housing upper side (14) having access to a printing material receptacle (18) of a printer device, and **in that** the supporting bracket (4) can be pivoted through an angle (α) of 180° over a housing rear side (30), between a first position (I) in a region underneath a housing lower side (28) and a second position (II) in a region above the housing upper side (14),
wherein the supporting bracket (4) is formed from a plastic material and wherein the plastic material is a composite fiber material and has glass fibers.

2. Vehicle data recording device according to Claim 1,
**characterized in that** the distance (AP) between a plate central axis (P) which intersects perpendicularly a mounting face of the mounting plate (24), and the pivoting axis (S) is larger than zero.

3. Vehicle data recording device according to Claim 1 or 2,
**characterized in that** the supporting limbs (20, 22) are of planar design and are connected to the mounting plate (24) at an angle of 90°, **in that** the first supporting limb (20) has, in its supporting limb plane, a bent portion (34) starting from the pivoting axis (S) in the direction of the mounting plate (24), and **in that** the second supporting limb (22) has a bent portion (36) which corresponds to the bent portion (34) of the first supporting limb (20), with the result that the supporting limbs (20, 22) run in parallel.

4. Vehicle data recording device according to one of the preceding claims, **characterized in that** the housing (2) is respectively connected by means of a screwed connection (23, 25) to the first supporting limb (20) and to the second supporting limb (22).

5. Vehicle data recording device according to Claim 4,
**characterized in that** the supporting limbs (20, 22) have cutouts (38, 40) in the region of the screwed connections (23, 25), and **in that** the supporting limbs (20, 22) are respectively screwed to the housing (2) by means of a screw-in element (21, 27).

6. Vehicle data recording device according to Claim 4 or 5,
**characterized in that** the housing (2) respectively has a screw nut element in the region of the screwed connections (23, 25).

7. Vehicle data recording device according to one of the preceding claims,
**characterized in that** the housing (2) has, on its outer side, housing latching elements which are arranged radially around the pivoting axis (S).

8. Vehicle data recording device according to Claim 7,
**characterized in that** the housing (2) is screwed to both supporting limbs (20, 22), and **in that** the housing (2) has the housing latching elements on both screwed connections (23, 25) to the supporting limbs (20, 22).

9. Vehicle data recording device according to one of the preceding claims,
**characterized in that** at least one supporting limb (22) has, on its limb surface facing the housing (2), supporting limb latching elements (42) which are arranged radially around the pivoting axis (S).

10. Vehicle data recording device according to Claim 9,
**characterized in that** the supporting limb latching elements (42) correspond to housing latching elements on the outside of the housing (2), with the result that the supporting limb latching elements (42) and the corresponding housing latching elements engage one in the other.

11. Vehicle data recording device according to one of the preceding claims,
**characterized in that** the mounting plate (24) has, in its mounting face, a plurality of mounting cutouts (32), wherein the mounting cutouts (32) are arranged in at least two parallel rows.

12. Vehicle data recording device according to one of the preceding claims,
**characterized in that** the mounting plate (24) has, in its mounting face, a cutout (33) for a cable feedthrough.

13. Vehicle data recording device according to one of the preceding claims,
**characterized in that** the operator control element (8) of the housing front side (6) has a touch-sensitive screen (10).

## Revendications

1. Appareil d'enregistrement de données de véhicule (1), comprenant un boîtier (2) faisant face à un utilisant et possédant une face avant de boîtier (6) pourvue d'un élément de commande (8), et comprenant un étrier porteur (4) en forme de U destiné à fixer le boîtier (2) dans un véhicule automobile, l'appareil d'enregistrement de données de véhicule possédant un émetteur et/ou un récepteur de signaux radioélectriques servant à la communication externe,
le boîtier (2) étant relié, de manière à pouvoir pivoter autour d'un axe de pivotement (S), avec une première branche porteuse (20) et une deuxième branche porteuse (22) de l'étrier porteur (4), l'axe de pivotement (S) étant disposé au-dessus d'un axe central de boîtier (M) référencé sur la hauteur (H) du boîtier (2) et
le plus petit écart (AK) entre l'axe de pivotement (S) et une plaque de fixation (24) de l'étrier porteur (4) qui relie les branches porteuses (20, 22) étant supérieur au plus grand écart (AG) entre l'axe de pivotement (S) et une paroi de boîtier (26) côté arrière du boîtier (2), **caractérisé en ce que** l'appareil d'enregistrement de données de véhicule (1) est un tachygraphe, **en ce que** le boîtier (2) possède un côté supérieur de boîtier (14) qui présente un accès à un logement de matériel d'impression (18) d'un dispositif d'impression et **en ce que** l'étrier porteur (4) peut pivoter entre une première position (I) dans une zone au-dessous d'un côté inférieur de boîtier (28) et une deuxième position (II) dans une zone au-dessus du côté supérieur de boîtier (14) sur un angle (α) de 180° sur une face arrière de boîtier (30),
l'étrier porteur (4) étant constitué d'une matière plastique et la matière plastique possédant un matériau renforcé par des fibres et des fibres de verre.

2. Appareil d'enregistrement de données de véhicule selon la revendication 1, **caractérisé en ce que** l'écart (AP) entre un axe central de plaque (P) qui croise perpendiculairement une surface de fixation de la plaque de fixation (24) et l'axe de pivotement (S) est supérieur à zéro.

3. Appareil d'enregistrement de données de véhicule selon la revendication 1 ou 2, **caractérisé en ce que** les branches porteuses (20, 22) sont de configuration plane et sont reliées à la plaque de fixation (24) sous un angle de 90°, **en ce que** la première branche porteuse (20) présente un pliage (34) dans son plan de branche porteuse en partant de l'axe de pivotement (S) en direction de la plaque de fixation (24) et **en ce que** la deuxième branche porteuse (22) présente un pliage (36) correspondant au pliage (34) de la première branche porteuse (20), de sorte que les branches porteuses (20, 22) s'étendent en parallèle.

4. Appareil d'enregistrement de données de véhicule selon l'une des revendications précédentes, **caractérisé en ce que** le boîtier (2) est relié respectivement par un assemblage vissé (23, 25) avec la première branche porteuse (20) et avec la deuxième branche porteuse (22).

5. Appareil d'enregistrement de données de véhicule selon la revendication 4, **caractérisé en ce que** les branches porteuses (20, 22) possèdent dans la zone des assemblages vissés (23, 25) des cavités (38, 40) et **en ce que** les branches porteuses (20, 22) sont fixées par vissage au boîtier (2) respectivement au moyen d'un élément à visser (21, 27).

6. Appareil d'enregistrement de données de véhicule selon la revendication 4 ou 5, **caractérisé en ce que** le boîtier (2) possède dans la zone des assemblages vissés (23, 25) respectivement un élément écrou à vis.

7. Appareil d'enregistrement de données de véhicule selon l'une des revendications précédentes, **caractérisé en ce que** le boîtier (2) possède sur son côté extérieur des éléments d'enclenchement de boîtier disposés de manière radiale autour de l'axe de pivotement (S).

8. Appareil d'enregistrement de données de véhicule selon la revendication 7, **caractérisé en ce que** le boîtier (2) est fixé par vissage aux deux branches porteuses (20, 22) et **en ce que** le boîtier (2) possède les éléments d'enclenchement de boîtier au niveau des deux assemblages vissés (23, 25) avec les branches porteuses (20, 22).

9. Appareil d'enregistrement de données de véhicule selon l'une des revendications précédentes, **caractérisé en ce qu'**au moins une branche porteuse (22) possède sur sa surface de branche qui fait face au boîtier (2) des éléments d'enclenchement de branche porteuse (42) disposés de manière radiale autour de l'axe de pivotement (S).

10. Appareil d'enregistrement de données de véhicule selon la revendication 9, **caractérisé en ce que** les éléments d'enclenchement de branche porteuse (42) correspondent aux éléments d'enclenchement de boîtier sur le côté extérieur du boîtier (2), de sorte que les éléments d'enclenchement de branche porteuse (42) et les éléments d'enclenchement de boîtier correspondants viennent en prise les uns dans les autres.

11. Appareil d'enregistrement de données de véhicule selon l'une des revendications précédentes, **caractérisé en ce que** la plaque de fixation (24) possède dans sa surface de fixation une pluralité de cavités de fixation (32), les cavités de fixation (32) étant disposées en au moins deux rangées parallèles.

12. Appareil d'enregistrement de données de véhicule selon l'une des revendications précédentes, **caractérisé en ce que** la plaque de fixation (24) possède dans sa surface de fixation une cavité (33) pour une traversée de câble.

13. Appareil d'enregistrement de données de véhicule selon l'une des revendications précédentes, **caractérisé en ce que** l'élément de commande (8) de la face avant de boîtier (6) possède un écran tactile (10).
